# EUROPEAN PATENT APPLICATION

(11) **EP 2 381 579 A1**
(43) Date of publication of application: **26.10.2011**
(21) Application number: 10160391.8
(22) Date of filing: 20.04.2010
(51) Int. Cl.: H03M 7/30

(54) **Method for compressing/decompressing data**

(71) Applicant: Itron Metering Solutions UK Ltd, Felixtowe, Suffolk IP11 2ER (GB)
(72) Inventor: Robins, Mark, Ipswich, Suffolk IP5 2DQ (GB)
(74) Representative: Hervouet, Sylvie

(57) **Abstract**

The invention relates to method for compressing and decompressing data for a communication network in which compressed data are exchanged between an originating device (4) and a destination device (5). The method comprises an initial phase comprising the steps of defining a structure of data to be compressed and identifying separate groups within said structure of data; defining a compression schema including a plurality of elementary compression algorithms, each elementary compression algorithm being adapted for the compression of one particular group among said separate groups; Assigning a unique signature to said compression schema; and storing said compression schema and corresponding unique signature in at least said originating device (4); then, for each subsequent phase for exchanging compressed data, the originating device (4) transmits to the destination device (5), data (M₃) which have been compressed according to said compression schema together with corresponding unique signature.

## Description

The invention relates to the transfer of data using compression algorithms for applications in which relatively small amounts of data need to be transferred over a low-bandwidth network.

One field of use particularly targeted by the invention concerns the transmission of metering and telemetry data between devices within a system over protocols such as Short Message Services or GPRS on a GSM network, power line communications at low data rates, or radio communications where low bandwidth is available.

The approach to data compression today in such applications is to use a general-purpose algorithm on the whole message before transmission, for example the well-known Lempel-Ziv algorithm and related algorithms. Such algorithms belong to a category of lossless compression techniques known as dictionary coding techniques, which rely upon the observation that recurring patterns occur in data to be compressed. The idea is then to replace those recurring patterns by shorter references to a dictionary within which the original pattern has been stored.

However, general-purpose algorithms are effective when there is sufficient data to find patterns. When transmitting a relatively small amount of data, such algorithms are unable to reduce the data size significantly, and in some cases can even increase the size of the data.

There is thus a need to find a new approach for systems in which the amount of data to be transferred can be relatively small, but data compression remains important to minimise the amount of data transmitted and thus, to optimise the usage of the communication network.

According to a first aspect of the invention, a method for compression and decompression of data is disclosed, in which compressed data are exchanged between an originating device and a destination device, characterized in that said method comprises an initial phase comprising the steps of:
- Defining a structure of data to be compressed and identifying separate groups within said structure of data;
- Defining a compression schema including a plurality of elementary compression algorithms, each elementary compression algorithm being adapted for the compression of one particular group among said separate groups;
- Assigning a unique signature to said compression schema;
- Storing said compression schema and corresponding unique signature in at least said originating device;
and in that each subsequent phase for exchanging compressed data between said devices comprises transmitting, from the originating device to the destination device, data which have been compressed according to said compression schema together with corresponding unique signature.

According to some other aspects of the invention:
- said initial phase may further comprise storing said compression schema and corresponding unique signature in said destination device.
- said initial phase may further comprise transmitting said compression schema and corresponding unique signature from said originating device to said destination device.
- said compression schema and corresponding unique signature may be included in a XML file.
- each subsequent phase may further comprise, at said destination device, the following steps:
   o Reception of compressed data and extraction of the unique signature from the received compressed data;
   o Retrieval of the compression schema associated to said unique signature;
   o Decompression of data according to the retrieved compression schema.
- In case no compression schema has been retrieved from said unique signature, the method advantageously comprises the following steps at said destination device:
   o Generation and transmission of a schema request to said originating device;
   o Upon reception of a response including compression schema together with corresponding unique signature, decompression of data according to said compression schema.

According to a second aspect of the invention, a communication network is disclosed in which compressed data are exchanged between an originating device and a destination device according to the method, characterized in that said originating device comprises:
- Means for storing at least a compression schema and corresponding unique signature;
- A transformation module for applying compression to raw data according to said compression schema and delivering compressed data; and
- Communications interface module for transmitting said compressed data with corresponding unique signature to said destination device.

These and other features of the present invention will be described in more detail below in the detailed description of the invention and in conjunction with the following figures:
- Figures 1 and 2 show an example of structure of data to be compressed;
- Figure 3 represents an example of an XML compression schema adapted for compressing the structure of data of figure 2;
- Figure 4 represents the resulting compressed data according to the compression schema of figure 3 using simple compression algorithms referenced in the schema;
- Figure 5 illustrates exchanges of compressed data between an originating device and a destination device in a first embodiment of a communication network implementing the method according to the invention;
- Figure 6 illustrates exchanges of compressed data between an originating device and a destination device in a second embodiment of a communication network implementing the method according to the invention;
- Figure 7 shows successive steps performed at the destination device of figure 6.

Basically, the invention proposes to define a compression schema, which is agreed between devices exchanging compressed data, by first defining the structure of the data to be compressed, and determining how separate elements of the data may be compressed using knowledge of the data structure. In this way, the data may be restructured and regrouped according to the compression schema, and individual data groupings compressed using different algorithms optimised depending on the nature of the data for maximum compression.

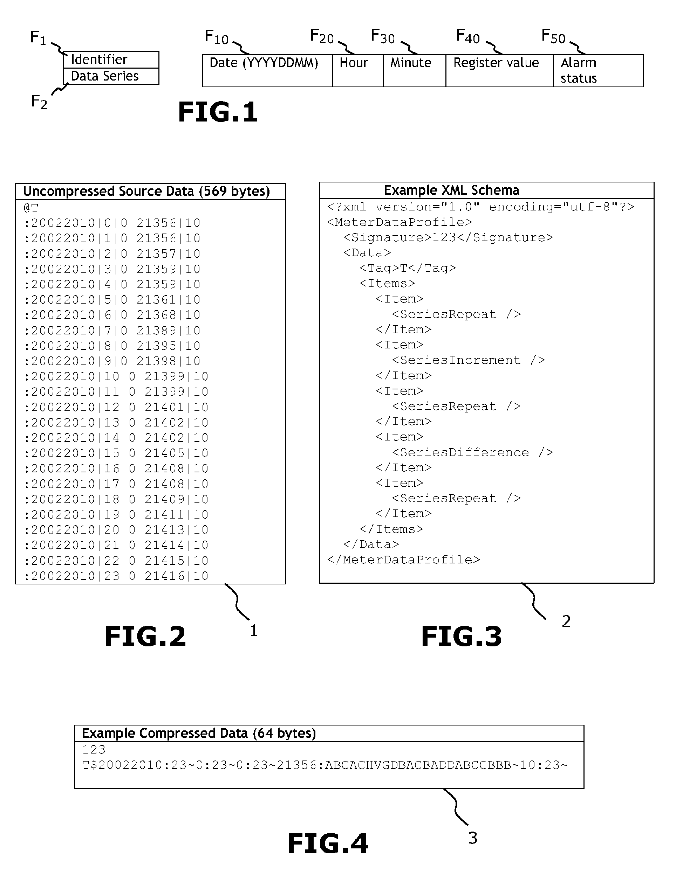

Figures 1 to 4 give an illustration of how a data compression schema can achieve very high data compression on a small amount of data. It should be however noted that the arrangement of source data, the design of a data compression schema, and the selection of compression algorithms are not per se in the scope of this invention, and in the example below, the purpose is to show that even with very simple compression algorithms, the schema is able to configure a very effective data compression.

In the following example, metering data to be compressed is presented in tabular form with the structure 1 as defined on figures 1 and 2:

An identifier F₁ is for instance an "@" character followed by a "T" to identify total register readings from an electricity meter followed by a line feed. Data series F₂ is a number of register readings in the following format: Each row is preceded with a ":", values are separated with a "I" and each entry is followed by a line feed character.

Structure 1 of figure 2 shows by way of example twenty-four successive readings made by the electricity meter on October 20, 2002, for each hour of the day.

Within structure 1, it is possible to identify five separate groups represented on right part of figure 1, namely:
- A first group F₁₀ corresponding to the date (e.g. 20022010);
- A second group F₂₀ corresponding to the hours (e.g. 0 to 23);
- A third group F₃₀ corresponding to the minutes (e.g. 0, thus meaning that all the readings have been performed at each change of hour);
- A fourth group F₄₀ corresponding to the registered values, namely the cumulated counting performed by the meter at each hour of the day;
- A fifth group F₅₀ corresponding to an alarm status indicating the presence of alarms on the meter.

From the example of figure 2, one can deduce the following behaviours within each group:
- Values or pieces of data within first group F₁₀, third group F₃₀ and fifth group F₅₀ remain constant, which is frequently the case for this kind of value;
- Each value or piece of data within second group F₂₀ is the unitary increment of the previous value or piece of data within said group. Here again, this is frequently the case for this kind of values;
- Each value or piece of data within fourth group F₄₀ is a variable increment of the previous value or piece of data within said group.

According to the invention, elementary compression algorithms adapted for the compression of each group can then defined. In the above example, this will lead to the use of:
- a run-length encoding ("SeriesRepeat" in figure 3) for values of groups F₁₀, F₃₀ and F₅₀. For instance, the first element in a series is entered followed by a ":", then followed by the number of successive elements where each element is the same as the previous element. When an element is encountered that is not the same as the previous element, a ";" is appended, and the process repeated until the end of the series is reached. A "~" is then appended to indicate that the series is complete.

In the given example, compression of data from group F₁₀ will give 20022010:23~, compression of data from group F₃₀ will give 0:23~, and compression of data from group F₅₀ will give 10:23~.
- a compression algorithm ("Serieslncrement" in figure 3) consisting in replacing the group of successive pieces of data by a pair of values corresponding to the value of the first piece of data in the group and to the value of the constant increment for data from group F₂₀. For instance, the first element in a series is entered followed by a ":", then followed by the number of successive elements where each element is a unitary increment of the previous element. When an element is encountered that is not a unitary increment of the previous element, a ";" is appended, and the process repeated until the end of the series is reached. A "~" is then appended to indicate that the series is complete.

In the given example, compression of data from group F₂₀ will give 20022010:23~.
- A compression algorithm ("SeriesDifference" in figure 3) adapted for group F₄₀, consisting in replacing the group of successive pieces of data by a pair of values corresponding to the value of the first piece of data in the group and to a coded value representative of the variable increment . For instance, the first element in a series is entered followed by a ":", then for each successive element that is equal to the previous element or no more than 63 greater than the previous element, a Base64 digit is appended to the value of the difference between this element and the previous element. When an element is encountered that is outside of this range, a ";" is appended, and the process repeated until the end of the series is reached. A "~" is then appended to indicate that the series is complete.

In the given example, compression of data from group F₄₀ will give ABCACHVGDBACBADDABCCBBB~.

Figure 3 shows an example of compression schema 2 adapted for structure 1 of data of figure 2. The compression schema can be included in a XML file, although other formats could be used.

According to another feature of the invention, a unique signature is assigned to compression schema 2. In the example as shown, this unique signature is 123, and is advantageously included within the XML file. The file then includes successive instructions which correspond to the particular elementary algorithms adapted for the Compression/Decompression of each group. As shown on figure 3, "SeriesRepeat" algorithm is first used for first group F₁₀, then "SeriesIncrement" algorithm is used for second group F₂₀, then "SeriesRepeat" algorithm is again used for third group F₃₀, "SeriesDifference" algorithm is used for fourth group F₄₀, and "SeriesRepeat" algorithm is again used for fifth group F₅₀.

Figure 4 shows the compressed data 3 resulting from compression schema 2 of figure 3. In this example, the compressed data size is less than 12% of the original data size. The unique signature 123 is also included in the compressed data so that any destination device can know which compression schema must be used for decompressing the data.

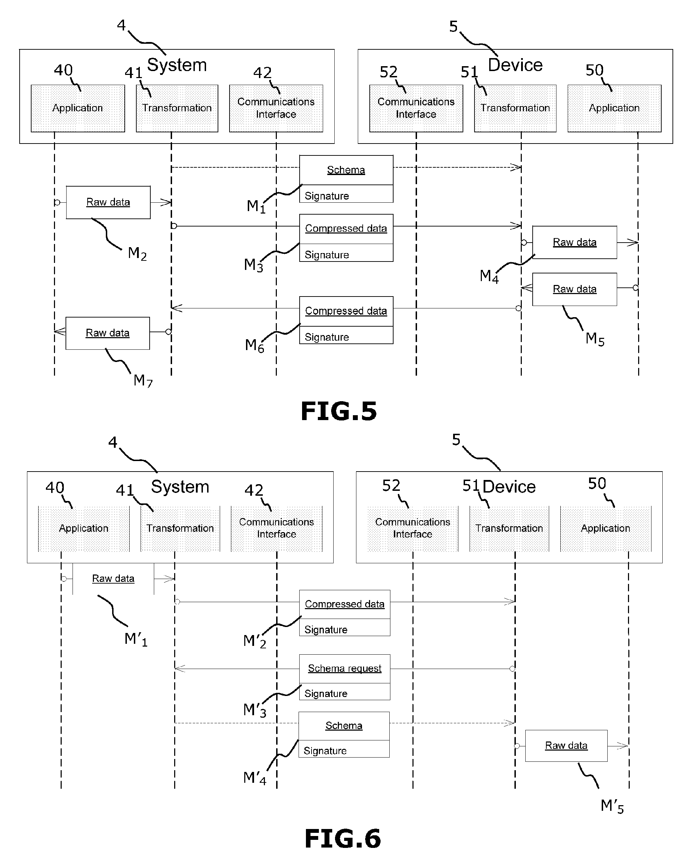

In reference to figure 5, a first embodiment of a communication network implementing the method of compression/decompression according to the invention will now be disclosed. In this network, compressed data are to be exchanged between an originating device 4 for instance a metering system adapted to collect information from several remote meters, and a destination device 5, for instance one particular remote meter. Data are exchanged between originating device 4 and destination device 5 via any communication means, including wired or wireless communication links.

Originating device 4 includes a first application module 40 from which data to be compressed are issued, a transformation module 41 for either compressing raw data delivered by application module 40 or decompressing compressed data received from destination device 5. At last, originating device 4 further includes a communications interface module to perform exchanges with destination device 5.

Destination device 5 also includes its own application module 50, for instance the metrology module, a transformation module 51 for either decompressing compressed data received from originating device 4 or compressing data delivered by application module 50, and a communications interface module 52 to perform exchanges with originating device 4.

According to the invention, a compression schema has been first defined during an initial phase and stored at originating device 4 together with the corresponding unique signature.

In normal usage, originating device 4 will send the data compression schema to any destination device 5 from which it expects to receive compressed data from according to the schema or to which it will send compressed data to according to the schema with the unique signature, created by the originating device. Figure 5 shows the transmission in message M₁ of a data compression schema together with the corresponding unique signature or identifier.

System 4 is therefore responsible to guarantee that the signature uniquely identifies a single data compression schema.

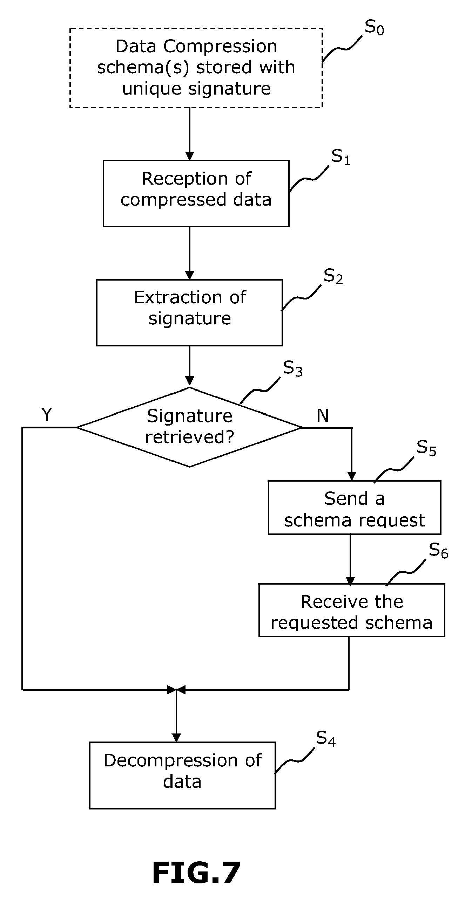

Upon receiving message M₁, destination device 5 can store the data compression schema and the signature, as indicated in step SO of figure 7. Alternatively, the schema may be pre-programmed in device 5.

Once the schema has been delivered, transformation module 41 can generate, from any raw data M₂ delivered by application module 40, data compressed according to said compression data schema, and transmits a message M₃, such as the example in Fig 4. already disclosed, including compressed data together with the corresponding signature, through communications interface module 42.

Message M₃ is received (step S₁ on figure 7) through communications interface 52 of destination device 5, and the signature can be extracted from the message (step S₂ on figure 7).

Since in this case the compression schema has already been stored within device 5 at step So, transformation module 51 can easily retrieve the schema from the extracted signature, and applies decompression of data according to this schema in order to deliver raw data M₄ to application module 52.

Originating device 4 can also receive message M₆ comprising compressed data and unique signature which could have been generated by destination device 5 from raw data M₅ delivered by application module 52. In this case, device 4 can also retrieve the compression schema from the unique signature, and transformation module can decompress the data according to the schema and deliver raw data M_{7.}

The system may send any number of different schemas to the device, each uniquely identified through a signature, allowing the selection of the optimum schema for any kind of data transmission.

Figure 6 illustrates another situation in which raw data M'₁ from application module 40 are first compressed according to a compression schema, message M'₂ including compressed data together with corresponding unique signature is then transmitted to destination device 5, but destination device is unable to retrieve the schema from the signature.

In this case, device 5 can hold the message, and generate and send an immediate schema request M'₃ to originating device 4 in order to receive the schema for the signature in the message (step S₅ on figure 7). The schema request M'3 shall also includes the corresponding unique signature, as shown on figure 6.

Originating device 4 will then answer to said request by transmitting message M'₄ including requested schema and corresponding signature.

Once response M'₄ has been received at destination device 5 (step S₆ on figure 7), the compressed data can be decoded and decompressed as already explained above (step S₄ on figure 7).

The present invention is straightforward to implement and allows very high compression rates due to prior knowledge of the data structure, and also by allowing structure data to be omitted from a transmission and reconstructed on data reception when the data is reassembled. It is effective on small amounts of data, but may equally be applied to large data sets. Additionally, the compressed data may be further compressed using a general-purpose compression algorithm, especially when the data set is relatively large.

Since data transmission time is reduced, system behaviour is more reactive in real time.

Moreover, where a network charges by transmission time or data quantity, costs savings are made due to the reduced message sizes.

The invention is particularly interesting where a system is required to communicate with a large number of devices in a short time period, for example in a smart metering system managing several million communicating meters. The network implementing the method of the invention may be deployed with reduced network bandwidth and fewer communication servers, and may be able to complete periodic communications more quickly, enabling data processing tasks to proceed at an earlier time.

Another interest concerns large data transfers on slow networks, such as aggregated data from many devices over GPRS, for example from a data concentrator. Thanks to the invention, such a data transfer can be performed in a substantially reduced timescale.

## Claims

1. A method for compressing and decompressing data for a communication network in which compressed data are exchanged between an originating device (4) and a destination device (5), **characterized in that** said method comprises an initial phase comprising the steps of:
- Defining a structure (1) of data to be compressed and identifying separate groups (F₁₀ - F₅₀) within said structure (1) of data;
- Defining a compression schema (2) including a plurality of elementary compression algorithms, each elementary compression algorithm being adapted for the compression of one particular group among said separate groups (F₁₀ - F_{50);}
- Assigning a unique signature to said compression schema (2);
- Storing said compression schema (2) and corresponding unique signature in at least said originating device (4);
and **in that** each subsequent phase for exchanging compressed data between said devices comprises transmitting, from the originating device (4) to the destination device (5), data (3) which have been compressed according to said compression schema (2) together with corresponding unique signature.

2. A method according to claim 1, **characterized in that** said initial phase further comprises storing (SO) said compression schema (2) and corresponding unique signature in said destination device (5).

3. A method according to claim 2, **characterized in that** said initial phase further comprises transmitting said compression schema (2) and corresponding unique signature from said originating device (4) to said destination device (5).

4. A method according to anyone of preceding claims, **characterized in that** said compression schema (2) and corresponding unique signature are included in a XML file.

5. A method according to anyone of preceding claims, **characterized in that** said each subsequent phase further comprises, at said destination device (5), the following steps:
- Reception (S₁) of compressed data and extraction (S₂) of the unique signature from the received compressed data;
- Retrieval (S₃) of the compression schema associated to said unique signature;
- Decompression (S₄) of data according to the retrieved compression schema.

6. A method according to claim 5, further comprising, in case no compression schema has been retrieved from said unique signature, the following steps at said destination device (5):
- Generation and transmission (S₅) of a schema request (M'₃) to said originating device (4);
- Upon reception of a response (M'₄) including compression schema (2) together with corresponding unique signature, decompression (S₄) of data according to said compression schema (2).

7. A method according to claim 6, **characterized in that** said schema request (M'3) comprises said unique signature.

8. A method according to anyone of preceding claims, **characterized in that** identifying separate groups within said structure (1) of data comprises identifying at least one group (F10 , F30 , F50) of successive identical pieces of data, for which adapted elementary compression algorithm is a run-length encoding.

9. A method according to anyone of preceding claims, **characterized in that** identifying separate groups within said structure (1) of data comprises identifying at least one group (F20) of successive pieces of data wherein each piece of data is a constant increment or decrement of the previous piece of data, for which adapted elementary compression algorithm consists in replacing the group of successive pieces of data by a pair of values corresponding to the value of the first piece of data in the group and to the value of said constant increment or decrement.

10. A method according to anyone of preceding claims, **characterized in that** identifying separate groups within said structure (1) of data comprises identifying at least one group (F40) of successive pieces of data wherein each piece of data is a variable increment or decrement of the previous piece of data, for which adapted elementary compression algorithm consists in replacing the group of successive pieces of data by a pair of values corresponding to the value of the first piece of data in the group and to a coded value representative of said variable increment or decrement.

11. Communication network in which compressed data are exchanged between an originating device (4) and a destination device (5) according to the method of anyone of the preceding claims, **characterized in that** said originating device (4) comprises:
- Means for storing at least a compression schema (2) and corresponding unique signature;
- A transformation module (41) for applying compression to raw data according to said compression schema and delivering compressed data; and
- Communications interface module (42) for transmitting said compressed data with corresponding unique signature to said destination device (5).

12. Communication network according to claim 11, **characterized in that** said originating device (4) is further adapted to transmit said compression schema (2) and corresponding unique signature to said destination device (5) through said communications interface module (42).

13. Communication network according to anyone of claims 11 or 12, **characterized in that** said destination device (5) comprises:
- Communications interface module (52) for receiving said compressed data with corresponding unique signature;
- Means for extracting said signature and retrieving compression schema from extracted signature; and
- A transformation module (51) for applying decompression to received compressed data according to the compression schema.

14. Communication network according to claim 13, **characterized in that** said destination device (5) is further adapted to generate and transmit a schema request (M'3) to said originating device (4) through said communications interface module (52) in case no compression schema has been retrieved from said unique signature.

15. Communication network according to anyone of claims 11 to 14, **characterized in that** said originating device is a metering system, destination device (5) is a utility meter, and compressed data which are exchanged include periodic readings from said utility meter and/or firmware downloads from said system.
